(19) Europäisches Patentamt / European Patent Office / Office européen des brevets

(11) **EP 2 277 271 B1**

(12) **FASCICULE DE BREVET EUROPEEN**

(45) Date de publication et mention
de la délivrance du brevet:
**05.07.2017 Bulletin 2017/27**

(21) Numéro de dépôt: **09745723.8**

(22) Date de dépôt: **12.05.2009**

(51) Int Cl.:
*H04B 3/46* $^{(2015.01)}$    *G01R 31/11* $^{(2006.01)}$

(86) Numéro de dépôt international:
**PCT/EP2009/055696**

(87) Numéro de publication internationale:
**WO 2009/138391 (19.11.2009 Gazette 2009/47)**

(54) **DISPOSITIF ET PROCÈDE DE RÉFLECTOMÉTRIE MULTIPORTEUSE POUR LE DIAGNOSTIC EN LIGNE D'AU MOINS UNE LIGNE DE TRANSMISSION**

MEHRTRÄGER-REFLEKTOMETRIEVORRICHTUNG UND VERFAHREN ZUR ONLINE-DIAGNOSEÜBERPRÜFUNG MINDESTENS EINER ÜBERTRAGUNGSLEITUNG

MULTICARRIER REFLECTOMETRY DEVICE AND METHOD FOR THE ON-LINE DIAGNOSTIC TESTING OF AT LEAST ONE TRANSMISSION LINE

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **14.05.2008 FR 0853114**

(43) Date de publication de la demande:
**26.01.2011 Bulletin 2011/04**

(73) Titulaire: **Commissariat à l'Énergie Atomique et aux Énergies Alternatives 75015 Paris (FR)**

(72) Inventeurs:
• **LELONG, Adrien**
**F-91400 Orsay (FR)**
• **OLIVAS, Marc**
**F-91120 Palaiseau (FR)**

(74) Mandataire: **Ilgart, Jean-Christophe et al BREVALEX 95, rue d'Amsterdam 75378 Paris Cedex 8 (FR)**

(56) Documents cités:
WO-A-02/078239

• NAIK S ET AL: "Multicarrier reflectometry" IEEE Sensors Journal IEEE USA, vol. 6, no. 3, juin 2006 (2006-06), pages 812-818, XP002507430 Stevenage, GB ISSN: 1530-437X cité dans la demande
• FARHANG-BOROUJENY B ET AL: "Transfer function identification with filtering techniques" IEEE Transactions on Signal Processing IEEE USA, vol. 44, no. 6, juin 1996 (1996-06), pages 1334-1345, XP002539218 ISSN: 1053-587X
• BUCCELLA C ET AL: "Detection and Localization of Defects in Shielded Cables by Time-Domain Measurements With UWB Pulse Injection and Clean Algorithm Postprocessing" IEEE TRANSACTIONS ON ELECTROMAGNETIC COMPATIBILITY, IEEE SERVICE CENTER, NEW YORK, NY, US, vol. 46, no. 4, 1 novembre 2004 (2004-11-01), pages 597-605, XP011122832 ISSN: 0018-9375 cité dans la demande
• JONES W W ET AL: "Sequence Time Domain Reflectometry (STDR) for Digital Subscriber LIne Provisioning and diagnostics" INTERNET CITATION, [Online] XP002203227 Extrait de l'Internet: URL:http://web2.mindspeed.com/mspd/news_ev ents/pdfs/stdr_tech.pdfhttp://w eb2.mindspeed.com/mspd/news_events/pdfs/st dr_tech.pdf> [extrait le 2002-06-24]

**Description**

**DOMAINE TECHNIQUE**

L'invention concerne un dispositif et un procédé de réflectométrie multiporteuse pour le diagnostic en ligne d'au moins une ligne de transmission, par exemple d'un réseau filaire.

Le domaine de l'invention est notamment celui du diagnostic embarqué de réseaux câblés par réflectométrie.

**ÉTAT DE LA TECHNIQUE ANTÉRIEURE**

Le but de la réflectométrie est de retracer les variations brusques de l'impédance caractéristique d'une ou plusieurs lignes de transmission qui peuvent correspondre à des branches ou des défauts (court-circuit, ou circuit ouvert), en déterminant les coefficients de réflexion $\alpha_k$ de la ou des lignes.

Le principe de la réflectométrie est basé sur la propagation d'ondes de tension dans ces lignes. Il consiste à envoyer un signal connu x(t) dans une ligne électrique et à mesurer ensuite le signal $x_s$(t) que renvoie la ligne. La mesure qui est faite est alors composée de l'ensemble des échos dus aux variations de l'impédance caractéristique de la ligne. L'analyse de la mesure $x_s$(t) par rapport au signal original x(t) donne une estimation de la réponse de la ligne.

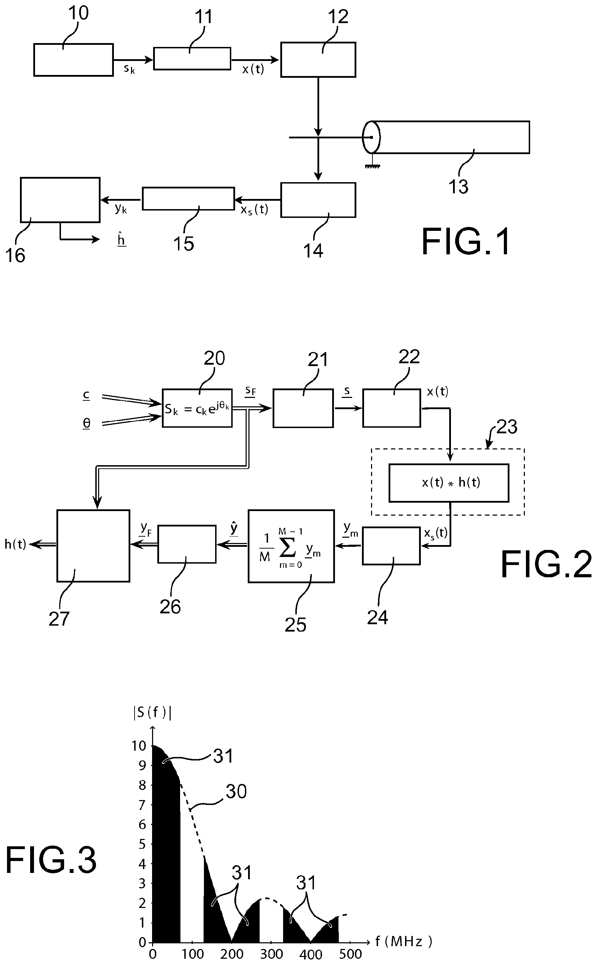

Le schéma de la figure 1 illustre le fonctionnement général d'un dispositif de réflectométrie. Sur cette figure sont représentées :

- une partie émission qui comprend :

  - un générateur de forme 10,
  - un convertisseur numérique-analogique 11,
  - un premier dispositif de couplage électrique 12 relié à la ligne à diagnostiquer 13,

- une partie détection qui comprend :

  - un second dispositif de couplage électrique 14 relié à la ligne 13,
  - un convertisseur analogique-numérique 15,
  - un dispositif de moyennage et de traitement du signal 16.

Le signal x(t) envoyé sur la ligne 13 par la partie émission est soumis à des contraintes propres à l'application et à la méthode de réflectométrie utilisée. Le couplage électrique a pour rôle de réaliser l'interfaçage entre le dispositif de réflectométrie (émission, réception du signal) et la ligne 13 en assurant des fonctions telles que l'adaptation d'impédance, la protection électrique ou encore un éventuel filtrage.

La relation entre $x_s$(t) et x(t) est donnée par la relation : $x_s$(t)=x(t)∗h(t), ∗ représentant le produit de convolution. Dans le domaine fréquentiel on obtient la relation : $X_s$(*f*)=X(*f*)H(*f*).

h(t) comprend une suite d'impulsions de type dirac telles que :

$$h(t) = \sum \alpha_k \delta(t - \tau_k) \qquad (1)$$

Le dispositif de réflectométrie a pour objet de mesurer avec un maximum de précision ce signal h(t), que l'on appelle « réponse de la ligne ».

Avec un réseau de câbles, la réflectométrie consiste à émettre un signal sur ce réseau de câbles puis à mesurer les échos renvoyés. Le retard et l'amplitude de ces échos permettent d'obtenir des informations sur la structure ou sur les défauts électriques présents dans ce réseau. Plus généralement, chaque écho correspond à une singularité. On peut ainsi localiser, caractériser et éventuellement prédire une panne. Les méthodes classiques bien connues de réflectométrie sont la réflectométrie TDR (« Time Domain Reflectometry ») et la réflectométrie FDR (« Frequency Domain Reflectometry »).

Lorsque l'on désire faire un diagnostic en ligne ou « on line », on envoie les signaux de réflectométrie sur le réseau lorsque le système cible est en fonctionnement. Cela permet d'établir un diagnostic beaucoup plus poussé du réseau car on se trouve dans les conditions de fonctionnement réelles du système. En outre, il est possible de détecter des défauts transitoires. Il faut cependant éviter toute interférence entre les signaux liés au fonctionnement du système cible et la réflectométrie. Cela se traduit par diverses contraintes (variables d'une application à l'autre) au niveau CEM (« compatibilité électromagnétique »), occupation spectrale des signaux ou encore robustesse au bruit. Des techniques spécifiques de réflectométrie doivent donc être mises en oeuvre pour s'adapter à ces contraintes.

Plusieurs méthodes de réflectométrie de l'art connu permettent de répondre, dans certains cas d'applications, aux contraintes d'un diagnostic en ligne. On peut citer :

- la réflectométrie STDR (« Sequence Time Domain Reflectometry »), comme décrit dans le document référencé [1] en fin de description : cette méthode est également intéressante pour le diagnostic « off line » (ou non connecté). Elle permet de réduire l'amplitude du signal émis en gardant les mêmes performances qu'une réflectométrie TDR classique. Elle peut être mise en oeuvre dans un système numérique.

- la réflectométrie SSTDR (« Spread Spectrum Time Domain Reflectometry »), comme décrit dans le document référencé [1] : cette méthode basée sur la réflectométrie STDR permet de déplacer le spectre du signal émis grâce à l'ajout d'une partie analogique, ce qui permet de diminuer la puissance injectée dans les basses fréquences. Cependant l'occupation spectrale est deux fois plus importante qu'avec la réflectométrie STDR et le spectre peut juste être décalé mais pas déformé.

- la réflectométrie NDR (« Noise Domain Reflectometry »), comme décrit dans le document référencé [2] : cette méthode permet de faire de la réflectométrie sans émettre aucun signal. Ce sont les signaux déjà présents sur la ligne qui sont utilisés. Bien que cette méthode puisse être intéressante dans certains cas, elle présente des inconvénients majeurs :

  - Les signaux présents dans le réseau de câbles doivent avoir les propriétés adéquates.
  - Les traitements sont plus complexes.
  - Les signaux de test ne sont pas périodiques ce qui a des conséquences sur la complexité du traitement et sur la qualité de la mesure.

- la réflectométrie MCR (« MultiCarrier Reflectometry »), comme décrit dans le document référencé [3] : l'intérêt de cette méthode utilisant des signaux multiporteuses est la grande flexibilité avec laquelle on peut moduler le spectre du signal émis, ce qui permet ainsi de s'adapter à des contraintes propres au diagnostic en ligne. Par exemple, s'il est interdit d'émettre sur une bande de fréquence située au milieu du spectre du signal test, il est tout à fait possible d'annuler l'énergie du signal sur cette bande de fréquence. La méthode proposée reste cependant très limitée car elle ne permet de diagnostiquer que des lignes simples et uniformes.

Ces méthodes de l'art connu pour un diagnostic « en ligne » souffrent d'un manque de flexibilité en termes de paramétrage. Ainsi, ces méthodes ne permettent pas toujours de se plier au contraintes des applications pour un tel diagnostic en ligne. Un des aspects importants du diagnostic en ligne est l'occupation spectrale du signal test émis sur le réseau de câbles. En effet le spectre du signal doit, d'une part, satisfaire les normes CEM de l'application et, d'autre part, permettre de limiter les interférences avec le fonctionnement de l'application.

L'invention a pour objet de pallier ces inconvénients et de permettre un diagnostic en ligne qui peut être appliqué à une topologie totalement arbitraire de réseau électrique.

## EXPOSÉ DE L'INVENTION

L'invention concerne un dispositif de réflectométrie multiporteuse pour le diagnostic en ligne d'au moins une ligne de transmission, caractérisé en ce qu'il comprend :

- une partie émission reliée à cette ligne de transmission qui comporte successivement :

  - un module de paramétrage d'un signal test $S_F$, tel que :

$$S_F = [0, c_1 e^{j\theta_1}, c_2 e^{j\theta_2}, \ldots, C_{N/2-1} e^{j\theta_{N/2-1}}, C_{N/2}, C_{N/2-1} e^{j\theta_{N/2-1}},$$

$$c_{N/2-2} e^{j\theta_{N/2-2}}, \ldots, c_1 e^{j\theta_1}]^T$$

  - un module de synthèse de ce signal test par transformée de Fourier discrète inverse,
  - un convertisseur numérique-analogique, relié à cette ligne de transmission, qui délivre à celle-ci un signal test analogique $x(t)$ qui est un signal périodique,

- une partie détection, reliée à cette ligne de transmission, qui comporte successivement :

- un convertisseur analogique-numérique, relié à cette ligne de transmission, qui reçoit un signal mesuré $x_s(t)$ et qui le numérise,
- un module de transformée de Fourier discrète,
- un module d'analyse contenant un module de déconvolution, qui réalise un post-traitement du signal mesuré ainsi transformé en utilisant le signal de test $S_F$ et qui permet d'estimer la réponse $h(t)$ de transmission, telle que $x_s(t)=x(t)*h(t)$, * représentant un produit de convolution.

Avantageusement, l'invention concerne un dispositif dans lequel le module d'analyse comprend des moyens d'inter-corrélation entre le signal émis et le signal mesuré. Le module d'analyse peut comprendre des moyens de post-traitement. Les moyens de post-traitement peuvent réaliser une déconvolution brute en appliquant l'équation suivante :

$$h_k^F \;=\; \frac{y_k^F}{s_k^F}$$

où $h_k^F$ , $y_k^F$ , et $s_k^F$ correspondent respectivement aux échantillons des vecteurs $\hat{\underline{h}}_F$, $y_F$ et $s_F$, transformées de Fourier discrètes des vecteurs $\hat{\underline{h}}$, $y$ et $s$, chaque période du signal mesurée $x_s(t)$ permettant d'obtenir une suite de vecteurs $\underline{y}_m$ de longueur N, la moyenne obtenue par un moyennage de plusieurs périodes étant stockée dans un vecteur $\underline{y}$. Les moyens de post-traitement peuvent réaliser un algorithme de nettoyage, qui comprend des étapes de :

- initialisation,
- recherche du maximum,
- nettoyage après un test de condition d'arrêt,
- mémorisation.

Le convertisseur analogique-numérique peut comprendre des moyens de sur-échantillonnage. Des moyens de filtrage analogique peuvent être insérés après le convertisseur numérique-analogique.

L'invention concerne également un procédé de réflectométrie multiporteuse pour le diagnostic en ligne d'au moins une ligne de transmission, caractérisé en ce qu'il comprend les étapes suivantes :

• en émission dans cette ligne de transmission :

- une étape de paramétrage d'un signal test $S_F$ tel que :

$$s_F=[0,c_1e^{j\theta_1},c_2e^{j\theta_2},\ldots,c_{N/2-1}e^{j\theta_{N/2-1}},c_{N/2},c_{N/2-1}e^{j\theta_{N/2-1}},$$
$$c_{N/2-2}e^{j\theta_{N/2-2}},\ldots,\;c_1e^{j\theta_1}]^T$$

- une étape de synthèse de ce signal test par transformée de Fourier discrète inverse,
- une étape de conversion numérique-analogique qui délivre à cette ligne de transmission un signal test analogique $x(t)$ qui est un signal périodique,

• en détection de cette ligne de transmission :

- une étape de conversion analogique-numérique du signal mesuré $x_s(t)$ reliée à cette ligne de transmission,
- une éventuelle étape de moyennage,
- une étape de transformée de Fourier discrète,
- une étape d'analyse permettant une déconvolution, qui réalise un post-traitement du signal ainsi transformé en utilisant le signal de test $s_F$ et qui permet d'estimer la réponse $h(t)$ de la ligne de transmission, telle que $x_s(t)=x(t)*h(t)$, * représentant un produit de convolution.

Avantageusement, l'invention concerne également un procédé dans lequel l'étape d'analyse comprend une phase d'inter-corrélation entre le signal émis et le signal mesuré. L'étape d'analyse peut comprendre une phase de post-traitement. La phase de post-traitement peut réaliser une déconvolution brute en appliquant l'équation suivante :

$$h_k^{F} = \frac{y_k^{F}}{s_k^{F}}$$

où $h_k^{F}$, $y_k^{F}$, et $s_k^{F}$ correspondent respectivement aux échantillons des vecteurs $\hat{h}_F$, $y_F$ et $s_F$, transformées de Fourier discrètes des vecteurs $\hat{h}$, y et s, chaque période du signal mesurée $x_s(t)$ permettant d'obtenir une suite de vecteurs $y_m$ de longueur N, la moyenne obtenue par un moyennage de plusieurs périodes étant stockée dans un vecteur $y$. L'étape de post-traitement peut réaliser un algorithme de nettoyage, qui comprend des étapes de :

- initialisation,
- recherche du maximum,
- nettoyage après un test de condition d'arrêt,
- mémorisation.

L'étape de conversion analogique-numérique peut comprendre une phase de sur-échantillonnage. Une phase de filtrage analogique peut être introduite après l'étape de conversion numérique-analogique.

Avantageusement, le module d'analyse utilisé dans le dispositif de l'invention contient un module de déconvolution dont le modèle de signal utilisé est indépendant de la topologie du réseau diagnostiqué. A la différence de la méthode de réflectométrie multiporteuse présentée dans le document référencé [3], qui ne permet que de diagnostiquer des lignes simples (i.e. : sans jonction) et uniformes (i.e. : sans variations d'impédance) en raison du modèle utilisé, la présente invention permet de diagnostiquer des réseaux de câbles complexes incluant plusieurs jonctions ainsi que des lignes non uniformes.

Des méthodes de déconvolution comme celle-ci n'ont pas été utilisées dans l'état de l'art connu pour le post-traitement de signaux de réflectométrie multiporteuse. Dans l'invention, cette déconvolution est réalisée au moyen d'un algorithme de déconvolution brute (qui consiste en une division spectrale) ou d'un algorithme de nettoyage ou bien les deux en fonction des paramètres du signal de test généré. En outre, l'objectif d'un tel algorithme de nettoyage dans le document référencé [5] est l'augmentation de la précision de la mesure. Dans la présente invention, l'objectif est d'estimer l'information manquante dans la mesure. Cette information manquante correspond aux bandes de fréquences ou l'énergie du signal test est nulle. Or, l'annulation (ou la réduction) de l'énergie dans ces bandes de fréquences permet au système de se plier aux contraintes CEM (compatibilité électromagnétique) de l'application ; c'est l'objectif de la réflectométrie multiporteuse.

L'invention propose donc une surcouche de la STDR permettant de réaliser l'objectif visé, à savoir l'application de la réflectométrie multiporteuse sur des réseaux complexes afin de pouvoir effectuer un diagnostic en respectant des contraintes CEM arbitraires.

L'étape de post-traitement du signal de réflectométrie est de complexité assez faible ce qui permet une intégration facile du procédé de l'invention dans un système embarqué. Par ailleurs le procédé de l'invention est entièrement numérique ce qui lui donne un net avantage par rapport à la réflectométrie SSTDR.

De nombreuses applications du dispositif et du procédé de l'invention sont possibles, notamment dans les domaines automobile, avionique...

## BRÈVE DESCRIPTION DES DESSINS

- La figure 1 illustre le synoptique d'un dispositif de diagnostic par réflectométrie de l'art connu.
- La figure 2 illustre le schéma de principe du dispositif de réflectométrie multiporteuse selon l'invention.
- La figure 3 illustre le spectre du signal de test obtenu en annulant les coefficients $c_i$ sur la bande FM.
- La figure 4 illustre un exemple de fonction d'auto-corrélation d'un signal multiporteuse.
- Les figures 5A et 5B illustrent un résultat typique obtenu avec une simple inter-corrélation, l'auto-corrélation du signal injecté correspondant à la courbe de la figure 4.
- La figure 6 illustre le principe de l'algorithme de nettoyage.
- Les figures 7A et 7B illustrent un résultat typique obtenu en réflectométrie multiporteuse selon l'invention, l'auto-corrélation du signal injecté correspondant à la courbe de la figure 4.
- La figure 8 illustre le spectre du signal mesuré dans le cas illustré sur les figures 7A et 7B.

**EXPOSÉ DÉTAILLÉ DE MODES DE RÉALISATION PARTICULIERS**

Le dispositif de réflectométrie multiporteuse pour diagnostic en ligne d'au moins une ligne de transmission selon l'invention est illustré sur le schéma de la figure 2.

Ce dispositif comprend :

• une partie émission qui comporte successivement :

- un module 20 de paramétrage d'un signal test $S_F$, au travers de vecteurs $\underline{c}$ et $\underline{\theta}$ tels que :

$$\underline{c} = [c_0, c_1, \ldots c_{N/2}]^T \text{ et } \underline{\theta} = [\theta_0, \theta_1, \ldots, \theta_{N/2}]^T \qquad (2)$$

qui délivre ce signal test qui contient des valeurs complexes et qui est tel que :

$$s_F = [0, c_1 e^{j\theta_1}, c_2 e^{j\theta_2}, \ldots, c_{N/2-1} e^{j\theta_{N/2-1}}, c_{N/2}, c_{N/2-1} e^{j\theta_{N/2-1}},$$

$$c_{N/2-2} e^{j\theta_{N/2-2}}, \ldots, c_1 e^{j\theta_1}]^T \qquad (3)$$

- un module 21 de synthèse de ce signal test par transformée de Fourier discrète inverse (IDFT),
- un convertisseur numérique-analogique 22 relié à la ligne 23,

• une partie de détection qui comporte successivement :

- un convertisseur analogique-numérique 24 relié à la ligne 23,
- un éventuel module de moyennage 25,
- un module de transformée de Fourier discrète 26,
- un module d'analyse 27 qui reçoit également le signal $s_F$.

La réflectométrie multiporteuse selon l'invention permet une modulation du spectre du signal test selon un cahier des charges donné, et de satisfaire les contraintes liées aux interférences entre la réflectométrie et le fonctionnement du système cible. Le signal émis peut s'écrire

$$s(kT_e) = \sum_{n-1}^{N/2} c_n \cos\left(\frac{2\pi n}{N} k + \theta_n\right) \qquad (4)$$

$Te = \dfrac{1}{F_e}$ est la fréquence d'échantillonnage.

N/2 correspond au nombre de sinusoïdes.

$c_n \in R^+$ est l'amplitude de la $n^{ième}$ sinusoïde.

$\theta_n$ est la phase de la $n^{ième}$ sinusoïde.

Le signal test défini par la relation (4) est synthétisé par la transformée de Fourier discrète inverse. Le vecteur $\underline{s}$ contient les échantillons d'une période du signal. Le vecteur $s_F$ correspond à la transformée de Fourier discrète du vecteur s. Le paramétrage du signal test se fait au travers des vecteurs $\underline{\theta}$ et $\underline{c}$, définis ci-dessus. Les convertisseurs numérique-analogique 11 et analogique-numérique 15 réalisent l'interface entre la partie numérique du dispositif contenant les algorithmes de calcul et la partie entrée-sortie analogique.

Après la transformée de Fourier discrète inverse 21 on obtient le vecteur s dont toutes les valeurs sont réelles. Ce vecteur définit le signal test à émettre sur la ligne 23. Ce signal test est un signal analogique x(t), obtenu après passage dans le convertisseur numérique-analogique 22, qui est un signal périodique de période $T = \dfrac{N}{F_e}$.

Le signal mesuré, $x_s(t)$ (également de période T) est numérisé par le convertisseur analogique-numérique 24. Chaque période mesurée permet d'obtenir une suite de vecteurs $\underline{y}_m$ de longueur N. Afin de maximiser le plus possible le rapport signal à bruit, on peut réaliser un moyennage 25 de plusieurs périodes. La moyenne obtenue est stockée dans un vecteur y. Cette possibilité de moyennage, qui est fondée sur le caractère périodique du signal mesuré, ne serait pas applicable dans le cas de la réflectométrie NDR. Pour des raisons de rapidité de calcul, les algorithmes d'analyse travaillent sur la transformée de Fourier du vecteur y désignée par le vecteur $y_F$. Afin de réellement profiter de cette rapidité de calcul, en profitant de la possibilité de calcul de la transformée de Fourier, on utilise un nombre N d'échantillons d'une période qui est une puissance de 2 (ie : $N=2^k$, $k \in N^*$).

L'algorithme d'analyse utilisé dans le module d'analyse 27 est différent selon que tous les coefficients $c_i$ sont nuls ou non.

Paramétrage du signal test (module 20)

Le paramétrage du signal test, qui est envoyé sur la ligne 23, permet d'adapter le dispositif de l'invention aux contraintes de l'application souhaitée. Les coefficients Ci du vecteur c déterminent la répartition de l'énergie du signal sur le spectre et ont un impact sur la qualité de la mesure. Les paramètres $\theta_i$ du vecteur $\underline{\theta}$ n'ont théoriquement aucune influence sur la qualité de la mesure. Par contre ces paramètres déterminent la dynamique du signal test, c'est à dire l'amplitude crête à crête.

Le spectre du signal de test x(t) s'étend théoriquement jusqu'à l'infini, mais les divers phénomènes de filtrage rencontrés font que, en pratique, on peut le considérer comme négligeable au delà de la fréquence d'échantillonnage $F_e$. Le spectre de ce signal de test x(t) sur la bande de fréquence $[0, F_e]$ est donné par

$$| S(f) | = \sum_{n-1}^{N/2} c_n \left[ \delta_{\frac{F_e n}{N}}(f) + \delta_{\frac{F_e(1-n)}{N}}(f) \right] |sin c(\pi f T_e)| \qquad (5)$$

Le symbole $\delta f_c(f)$ désigne une impulsion de dirac dont le pic est situé à la fréquence $f_c$.

Les coefficients $\theta_i$ du vecteur $\underline{\theta}$ peuvent être calculés de différentes manières :

- On peut ainsi les générer de façon aléatoire. Mais dans ce cas, on reste assez éloigné de l'optimum.
- On peut également les calculer en utilisant l'algorithme de Shroeder décrit dans le document référencé [4]. Une telle solution est acceptable en termes de dynamique. De plus, l'algorithme utilisé est simple, ce qui facilite son application.
- On peut, enfin, utiliser d'autres méthodes plus complexes, qui permettent d'obtenir des solutions plus proches de l'optimum (l'amplitude est encore plus faible). Mais le gain obtenu ne justifie pas forcément l'emploi de telles méthodes.

Dans le cas de la méthode décrite dans le document référencé [3], les phases sont simplement générées de façon aléatoire.

1) Exemple de paramétrage des coefficients $c_i$

Dans un exemple de réalisation, la fréquence d'échantillonnage $F_e$ est 200 MHz et on veut annuler le spectre du signal sur la bande [70,130 MHz] (qui contient la bande FM). La longueur du signal est N=512. Il y a donc 256 paramètres $c_i$ à définir. La fréquence de Shannon $F_e/2$ = 100 MHz se situe au milieu de la bande considérée. Il suffit donc d'annuler le spectre de 70 MHz à 100 MHz et l'autre partie de la bande est annulée par repliement de spectre. L'indice de l'élément du vecteur correspondant à $F_0$ = 70 MHz est :

$$N_0 = N \frac{F_0}{F_e} = 179$$

Le vecteur $\underline{c}$ est défini par

$$c_n = \begin{cases} 0 \text{ pour } n \in \{179, ..., 256\} \\ 1 \text{ sinon} \end{cases} \qquad (6)$$

Le spectre du signal de test s (t) obtenu est représenté sur la figure 3. Sur ce graphique la courbe 30 en pointillés représente le spectre d'un signal multiporteuse lorsque tous les coefficients $c_i$ sont égaux à 1, et la surface grisée 31 représente le spectre du signal obtenu en annulant les coefficients sur la bande FM.

Analyse du signal de réflectométrie (module 27)

Dans le cas où toutes les valeurs du vecteur c sont égales à 1, le dispositif de l'invention est équivalent à une réflectométrie STDR. En effet, dans ce cas, la densité spectrale de puissance (DSP) du signal multiporteuse est la même que celle d'un bruit pseudo aléatoire de type MSéquence. Une simple inter-corrélation du signal mesuré y avec le signal émis permet d'obtenir l'estimation correcte de la réponse de la ligne h(t).

L'inter-corrélation est calculée en utilisant la transformée de Fourier discrète qui permet un calcul plus rapide lorsque $N$ est une puissance de 2. L'équation utilisée est alors :

$$\underline{r}_{sy} = \mathrm{IDFT}\left[\mathrm{DFT}(\underline{y}) \odot \mathrm{DFT}(\underline{s})^*\right] = \mathrm{IDFT}\left[\underline{y}_F \odot \underline{s}^*_F\right] \qquad (7)$$

où :

$\underline{r}_{sy}$ désigne le résultat de l'inter-corrélation.

$\odot$ désigne le produit terme à terme de deux vecteurs.

.* désigne la valeur complexe conjuguée.

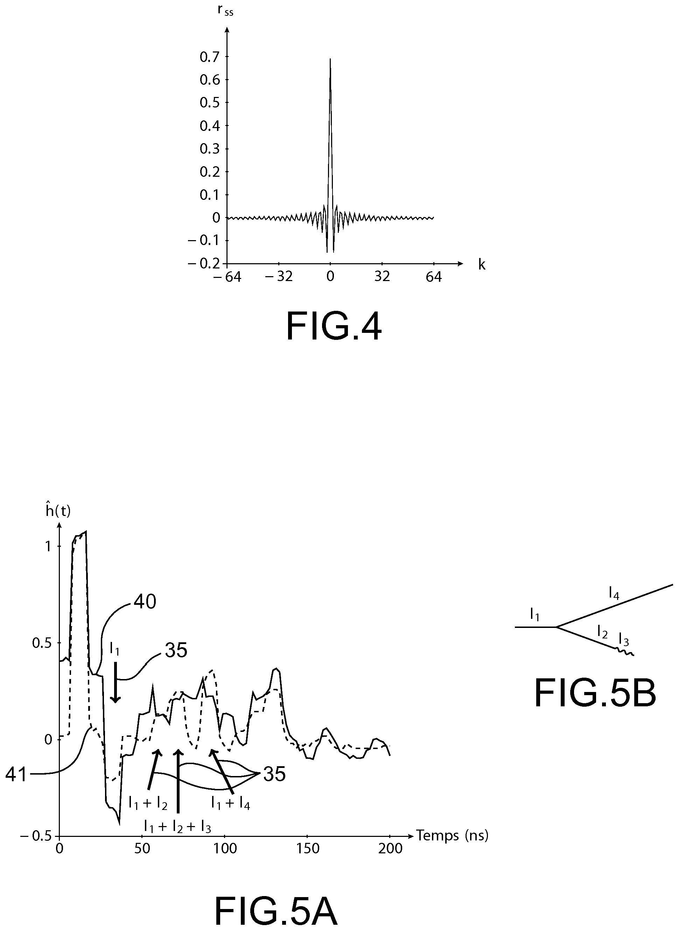

La réflectométrie multiporteuse selon l'invention permet de moduler librement les coefficients $c_i$. Or, lorsque le spectre du signal test n'est plus équivalent à la réflectométrie STDR, des pics parasites apparaissent lorsque l'on applique une simple inter-corrélation, ce qui rend le réflectogramme inexploitable. Cela est dû à la forme de la fonction d'auto-corrélation $\underline{r}_{ss}$ du signal s, dont on peut voir un exemple sur la figure 4 lorsque certains coefficients $c_k$ sont nuls. Dans le cas de la réflectométrie STDR, cette fonction d'auto-corrélation se résume à un pic unique. Dans le cas présent les lobes secondaires que l'on observe sont responsables de la distorsion.

L'influence de la fonction d'auto-corrélation s'explique par la relation entre l'inter-corrélation et l'auto-corrélation :

$$\underline{r}_{sy} = \hat{\underline{h}} * \underline{r}_{ss}$$

où * désigne le produit de convolution circulaire entre les deux vecteurs.

Le vecteur h correspond à une version discrétisée de la réponse impulsionnelle du réseau diagnostiqué. Etant donné que le signal de test émis par le dispositif de réflectométrie est échantillonné avec une période d'échantillonnage $T_e$ on peut exprimer les coefficients $h_n$ du vecteur en fonction de la réponse impulsionnelle h(t) (dans le domaine continu) par

$$h_n = \int_0^{T_e} h(t + nT_e)dt$$

En utilisant la relation (1) on obtient :

$$\underline{r}_{sy} = \sum_k \alpha_k \underline{r}_{ss}{}^{\circlearrowleft\tau_k} \qquad (8)$$

où $\underline{x}^{\circlearrowleft n}$ correspond à un décalage circulaire des éléments du vecteur x de n échantillons vers la droite.

En effectuant une simple inter-corrélation, on obtient un résultat de réflectométrie représenté sur la figure 5A, le réseau de lignes $l_i$, $l_2$, $l_3$, $l_4$ utilisé étant représenté sur la figure 5B. La courbe en trait plein 40 représente la réflectométrie TDR, et la courbe en pointillés 41 l'inter-corrélation. Les pics intéressants ne pouvant alors être identifiés là, le procédé de l'invention utilise un post-traitement réalisé dans le module d'analyse 27, qui permet d'estimer correctement la réponse de la ligne h(t). Les flèches 35 symbolisent la longueur aller-retour parcourue par le signal.

On va, à présent, considérer plusieurs cas de figure, dans lesquels différentes méthodes d'analyse peuvent s'appliquer.

1) Cas 1 : Tous les coefficients *ck sont* non nuls

Ce cas, dans lequel les parties gênantes du spectre sont atténuées mais pas annulées, est le cas le plus simple. On peut alors appliquer un algorithme de "déconvolution brute" ou de division spectrale, en appliquant l'équation suivante :

$$h_k^F \; = \; \frac{y_k^F}{s_k^F} \qquad (9)$$

où $h_k^F$, $y_k^F$, et $s_k^F$ correspondent respectivement aux échantillons des vecteurs $\hat{h}_F$, $y_F$ et $s_F$ (transformées de Fourier discrètes des vecteurs $\hat{h}$, $y$ et $s$). Le rapport entre les valeurs maximum et minimum du vecteur c est tel que :

$$\chi \; = \; \frac{\max(\underline{c})}{\min(\underline{c})} \qquad (10)$$

Ce rapport $\chi$, qui correspond au facteur d'atténuation appliqué aux fréquences gênantes, ne doit pas être trop grand. Plus cette valeur est importante, plus le nombre M de mesures moyennées doit être grand si l'on veut conserver un rapport signal à bruit correct. En pratique on considère un rapport $\chi \leq 10$, ce qui correspond à une différence de 20dB entre le maximum et le minimum d'énergie dans la densité spectrale de puissance du signal test.

2) Cas 2 : Certains coefficients $c_k$ sont égaux à 0

Lorsque l'on ne veut rien émettre dans une bande de fréquences donnée, on annule les coefficients $c_k$ correspondants. Dans ce cas, la méthode de déconvolution brute n'est pas applicable. On utilise alors, de façon originale, un algorithme de nettoyage ou "Clean Algorithm", qui est utilisé pour l'estimation de canal dans les transmissions UWB (« Ultra Wide Band »), comme décrit dans le document référencé [5].

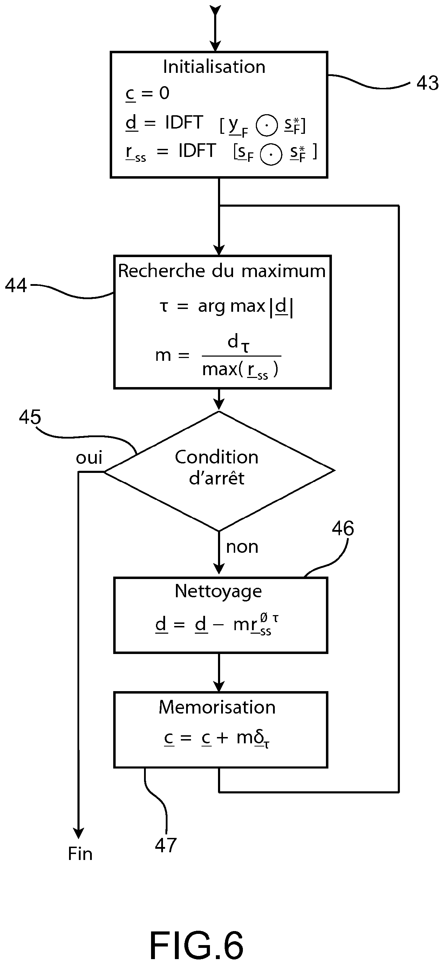

Dans le procédé de l'invention, un tel algorithme de nettoyage permet de tirer parti de la forme particulière de la fonction d'auto-corrélation. En effet, on remarque sur la figure 4 que malgré la présence de lobes secondaires, le pic central est très prononcé. La position des pics de forte amplitude est visible grâce à leur maximum. Les pics de plus petites amplitudes sont par contre cachés par les lobes secondaires des pics de fortes amplitudes. L'algorithme de nettoyage consiste donc à éliminer la contribution des pics au fur et à mesure de leur détection. La structure générale de l'algorithme de nettoyage, illustrée sur la figure 6, comprend des étapes de :

- initialisation (étape 43),
- recherche du maximum (étape 44),
- nettoyage (étape 46) après un test 45 de condition d'arrêt,
- mémorisation (étape 47), avec :

  - $\underline{x}^{\circlearrowright n}$ correspond à un décalage circulaire des éléments du vecteur x de n échantillons vers la droite.
  - $r_{ss}$ : vecteur d'auto-corrélation du signal $s$.
  - $\delta_n$ : vecteur dont tous les éléments sont nuls sauf le n$^{\text{ième}}$ qui est égal à 1.
  - $c$ : vecteur contenant le signal nettoyé.

L'étape de recherche du maximum 44 permet d'estimer l'amplitude et la position du pic de plus forte amplitude, la contribution de ce pic est ensuite éliminée lors de la phase de nettoyage 46 puis mémorisée. A l'itération suivante, le pic d'amplitude juste inférieure est détecté. La condition d'arrêt 45 peut être testée sur deux critères différents :

- L'amplitude de l'erreur : La condition d'arrêt se traduit alors par l'équation : $\max|\underline{d}| < \varepsilon$ ; $\varepsilon$ étant le seuil d'erreur résiduelle. En pratique, on choisit ce seuil $\varepsilon$ juste supérieur au niveau de bruit.
- Le nombre de pics : Lorsque l'on connaît la topologie du réseau filaire analysé, on peut facilement estimer le nombre maximum de pics pertinents dans le réflectogramme. L'algorithme s'arrête lorsque le nombre de pics détectés atteint une valeur prédéfinie.

Le choix de cette condition d'arrêt est davantage détaillé ci-dessous.

Plus précisément un tel algorithme de nettoyage, qui entre dans la catégorie des algorithmes de déconvolution, convient tout particulièrement à la déconvolution impulsionnelle, c'est-à-dire lorsque l'on considère que le signal recherché est composé d'impulsions ou de pics distincts. La mise en oeuvre de cet algorithme est simple, chaque itération est composée de quatre étapes et permet soit d'estimer la position et l'amplitude d'un nouveau pic ou bien d'affiner l'amplitude d'un pic déjà trouvé précédemment. Ainsi, le nombre d'itérations est supérieur ou égal au nombre de pics à détecter.

L'algorithme de nettoyage se déroule selon le schéma suivant : (tous les vecteurs utilisés ont une longueur de N échantillons)

### - Initialisation (étape 43)

- d=IDFT$\left[ Y_F \odot S_F^* \right]$ est le vecteur d'entrée de l'algorithme. Il correspond au signal obtenu après filtrage adapté. L'opérateur $\odot$ dénote le produit terme à terme des deux vecteurs et le symbole .* correspond aux valeurs conjuguées.

- r=IDFT$\left[ S_F \odot S_F^* \right]$ correspond au noyau de déconvolution de l'algorithme. Il s'agit ici de l'autocorrélation (circulaire) du signal test s.

$\hat{h}$ est initialisé à 0 et contient le résultat de l'algorithme. Ce résultat est une estimation du vecteur h d'où sa notation.

### - Boucle principale

a. Recherche du maximum (étape 44)

$$\tau = \arg\max|\underline{d}|$$

$$m = \frac{d_\tau}{\max(\underline{r}_{ss})}$$

où |.| dénote la valeur absolue. $\tau$ correspond alors à la position du maximum en valeur absolue.

b. Condition d'arrêt (étape 45) : elle est détaillée plus loin, si elle est vérifiée l'algorithme s'arrête ici.

c. Nettoyage (étape 46)

Pour n allant de 0 à N-1 :

$$d_n = d_n - mr_{\left(\overline{n-\tau}^N\right)}$$

$d_n$ et $r_n$ correspondent respectivement aux éléments des vecteurs d et r et $\overline{n}^N$ correspond à n modulo N.

d. Mémorisation (étape 47) : le pic détecté est ajouté au vecteur $\hat{h}$

$$\hat{h}_\tau = \hat{h}_\tau + m$$

Puis on retourne à l'étape (a).

A chaque itération le maximum (en valeur absolue) du vecteur d diminue. Lorsque l'algorithme s'arrête le contenu de ce vecteur correspond à l'erreur résiduelle. Ainsi, le test réalisé classiquement à l'étape (b) est de vérifier si le maximum de l'erreur est acceptable. Ce qui donne

arrêt si : m<$\varepsilon$

En pratique, on fixe $\epsilon$ à une valeur un peu supérieure à l'amplitude du bruit de mesure. C'est la condition d'arrêt utilisé dans le document référencé [5]. Cela revient à dire que l'on cherche à minimiser l'erreur résiduelle.

Dans le cas de l'invention, le problème est sous-déterminé, c'est-à-dire qu'il manque de l'information correspondant à la fréquence nulle du signal test (coefficient $c_n$ à 0). Il faut donc compenser ce manque d'information en guidant d'avantage l'algorithme. La mise en oeuvre de l'algorithme de nettoyage est donc différente de celle du document référencé [5], il faut une condition d'arrêt supplémentaire.

En pratique, il est possible d'estimer le nombre maximum de pics que l'on peut obtenir dans le réflectogramme en fonction de la topologie du réseau. On utilise donc une condition d'arrêt supplémentaire sur le nombre de pics. On peut compter le nombre de pics en modifiant l'étape (d) qui devient :

$$\text{si}\ \left(\hat{h}_{\tau}=0\right): p = p + 1$$

$$\hat{h}_{\tau} = \hat{h}_{\tau} + m$$

La condition d'arrêt est alors :
arrêt si : p=P
où P est le nombre maximum de pics.

Dans le cas de l'invention, il est idéal d'utiliser les deux conditions d'arrêt. Ce deuxième test permet d'éviter que le résultat colle trop aux données qui en réalité sont erronées en raison de l'information manquante.

3) <u>Cas 3 : Association des méthodes correspondant aux cas 1 et 2</u>

On peut associer les deux méthodes d'analyse décrites ci-dessus dans le cas d'applications qui nécessitent que le spectre du signal test soit à la fois atténué sur une certaine bande de fréquence (Cas 1) et annulé sur une autre bande de fréquences (Cas 2).

On applique d'abord la déconvolution brute (équation 9) en ignorant les points où le spectre est nul, ce qui se traduit par l'équation suivante :

$$g_k^F = \begin{cases} \dfrac{y_k^F}{s_k^F}\ \text{si}\ s_k^F \neq 0 \\[2em] 0\ \text{sinon} \end{cases} \qquad\qquad (11)$$

Le vecteur $\underline{g}$ (transformée de Fourier discrète inverse du vecteur $\underline{g}_F$) est une première estimation de la réponse, vecteur $\underline{h}$.

On applique ensuite l'algorithme de nettoyage, l'étape d'initialisation étant différente :

- Le signal d'entrée est le vecteur $\underline{g}$ tel que :

$$\underline{d}=\underline{g}$$

- La fonction d'auto-corrélation, qui ne correspond plus exactement au signal s, est donnée par :

$$\underline{r}_{ss} = IDFT(\underline{r}_{ss}^{F})$$

avec :

$$r_k^F = \begin{cases} \dfrac{s_k^F}{s_k^F} \ \text{si} \ s_k^F \neq 0 \\[2mm] 0 \ \text{ sinon} \end{cases} \qquad et \quad \underline{r}_{ss}^F = \left[ r_1^F, r_2^F, ..., r_N^F \right]^T \qquad (12)$$

On peut donc tirer avantage de ces deux méthodes d'analyse.

Variantes de l'invention

Le procédé de l'invention suppose que la fréquence d'échantillonnage est la même au niveau du convertisseur analogique-numérique 24 et du convertisseur numérique-analogique 22. En pratique on peut, pour augmenter la résolution du réflectogramme, sur-échantillonner le signal au niveau du convertisseur analogique-numérique 24. Ainsi, au niveau du convertisseur numérique-analogique 22, le signal est généré à une fréquence Fe mais le convertisseur analogique-numérique 24 échantillonne le signal mesuré à une fréquence $K.F_e$ où $K$ est un entier.

Dans ce cas, le moyennage du module 25 se fait de la même façon que précédemment. On obtient un vecteur :

$$\underline{y}_{se} = \left[ y_1, y_2, ..., y_{KN-1}, y_{KN} \right]^T.$$

Ce vecteur est éclaté en $K$ vecteurs $\underline{y}_1$ à $\underline{y}_k$ définis par :

$$\underline{y}_n = \left[ Y_n, Y_{n+K}, Y_{n+2K}, ... Y_{n+(N-1)K} \right]^T$$

L'algorithme d'analyse décrit ci-dessus est appliqué de façon indépendante sur chacun de ces vecteurs ce qui donne une suite de vecteurs $\underline{\hat{h}}_1$ à $\underline{\hat{h}}_k$ correspondant à :

$$\underline{h}_n = \left[ h_n, h_{n+K}, h_{n+2K}, ..., h_{n+(N-1)K} \right]^T$$

Le résultat final est ensuite reconstitué selon la relation :

$$\underline{h}_{se} = \left[ h_1, h_2, ..., h_{KN-1}, h_{KN} \right]^T$$

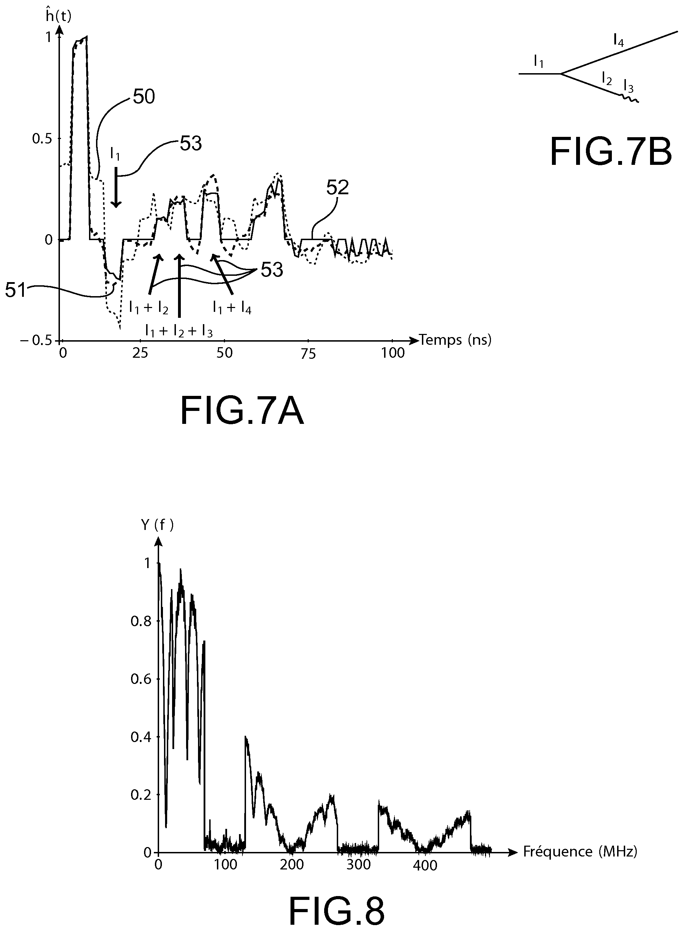

Un exemple de résultat obtenu sur un réseau de type Y est illustré sur la figure 7A.

Ce réseau de type Y de lignes $l_1$, $l_2$, $l_3$ et $l_4$ utilisé pour la mesure est illustré sur la figure 7B, les lignes $l_1$, $l_2$, $l_4$ étant des lignes coaxiales 50Ω et la ligne $l_3$ une paire torsadée. Sur la figure 7A, la courbe en pointillé 50 représente l'inter-corrélation, la courbe en tireté 51 représente la réflectométrie TDR et la courbe en trait plein 52 le combinaison de l'inter-corrélation et de l'algorithme de nettoyage. Les longueurs de ce réseau sont $l_1$=1m, $l_2$=1.5m, $l_3$=0.5m, $l_4$=3m. Le signal injecté correspond à celui défini par l'équation (6), le spectre de ce signal est nul sur la bande FM (76 MHz - 108 MHz) comme on peut le voir sur la courbe de la figure 3. L'utilisation de ce signal permet donc de ne pas perturber les transmissions radios sur cette bande lorsque le signal est émis en permanence. Le spectre du signal mesuré, qui est renvoyé par la ligne, est représenté sur la figure 8. On y retrouve les "bandes annulées" que l'on peut voir sur la figure 3. La seule composante visible dans ces bandes de fréquence correspond au bruit. Dans les bandes non nulles on observe les anti-résonnances liées au réseau diagnostiqué.

On peut, en outre, placer un filtre analogique après le convertisseur numérique-analogique 22 avant l'injection du signal dans la ligne 23, ce qui permet d'atténuer le spectre au delà de la fréquence d'échantillonnage (par exemple 200 MHz). Si la fréquence de coupure de ce filtre n'est pas trop basse, le résultat de réflectométrie reste correct.

Le post-traitement du procédé de l'invention permet de s'affranchir des lobes secondaires de la fonction d'auto-corrélation, illustré sur la figure 4. La courbe 52 en trait plein de la figure 7A représente le résultat final du procédé de l'invention et est à comparer avec la courbe 51 en tiretés de la réflectométrie TDR (affectée par aucune distorsion). Les flèches 53 symbolisent la longueur aller-retour parcourue par le signal.

Mise en oeuvre du procédé de l'invention

Les résultats obtenus ci-dessus l'ont été avec la mise en oeuvre du procédé de l'invention sous logiciel Matlab, l'injection et la récupération du signal se faisant via des appareils de laboratoire.

La mise en oeuvre du procédé de l'invention nécessite un système numérique pour la synthèse du signal et le post-traitement afin d'exécuter les différents algorithmes associés. L'intégration de cette partie numérique peut se faire dans un microcontrôleur, un réseau prédiffusé programmable par l'utilisateur (FPGA ou « Field Programmable Gate Array »), un circuit intégré spécifique (ASIC ou « Application Specific Integrated Circuit »), un poste de travail ou tout autre plateforme numérique adaptée à l'application. L'émission et la récupération du signal, qui se fait via une paire de convertisseur numérique-analogique (DAC) - convertisseur analogique-numérique (ADC), peut être assurée par des appareils de laboratoires (oscilloscope et générateur). On peut toutefois opter pour des convertisseurs inclus dans un microcontrôleur ou une carte électronique à FPGA ou microprocesseur.

**REFERENCES**

[1] "Analysis of spread spectrum time domain reflectometry for wire fault location" de P. Smith, C. Furse, et J. Gunther. (Sensors Journal, IEEE, 5(6), pages 1469-1478, décembre 2005).

[2] "Noise-domain reflectometry for locating wiring faults" de Chet Lo et C. Furse. (Electromagnetic Compatibility, IEEE Transactions on, 47(1), pages 97-104, février 2005).

[3] "Multicarrier reflectometry" de S. Naik, C.M. Furse, et B. Farhang-Boroujeny. (Sensors Journal, IEEE, 6(3), pages 812-818, juin 2006).

[4] "Synthesis of low-peak-factor signals and binary sequences with low autocorrelation" de M. R. Schroeder. (IEEE Transaction on information Theory, 16, pages 85-89, janvier 1970).

[5] "Detection and localization of defects in shielded cables by time-domain measurements with uwb pulse injection and clean algorithm postprocessing" de C. Buccella, M. Feliziani, et G. Manzi. (IEEE Transactions on Electromagnetic Compatibility, 46(4), pages 597-605, novembre 2004).

**Revendications**

1. Dispositif de réflectométrie multiporteuse pour diagnostic en ligne d'au moins une ligne de transmission (23), **caractérisé en ce qu'**il comprend :

   • une partie émission reliée à cette ligne de transmission (23) qui comporte successivement :

   - un module (20) de paramétrage d'un signal test $S_F$, tel que :

$$s_F = [0, c_1 e^{j\theta_1}, c_2 e^{j\theta_2}, \ldots, c_{N/2-1} e^{j\theta_{N/2-1}}, c_{N/2}, c_{N/2-1} e^{j\theta_{N/2-1}},$$
$$c_{N/2-2} e^{j\theta_{N/2-2}}, \ldots, c_1 e^{j\theta_1}]^T$$

   , où N correspond au nombre de sinusoïdes,
   $C_n \in R^+$ est l'amplitude de la $n^{ième}$ sinusoïde,
   $\theta^n$ est la phase de la $n^{ième}$ sinusoïde,
   - un module (21) de synthèse de ce signal test par transformée de Fourier discrète inverse,
   - un convertisseur numérique-analogique (22) relié à cette ligne de transmission (23), qui délivre à celle-ci un signal test analogique x(t) qui est un signal périodique,

   • une partie détection, reliée à cette ligne de transmission (23), qui comporte successivement :

- un convertisseur analogique-numérique (24) relié à cette ligne de transmission (23), qui reçoit un signal mesuré $x_s(t)$ et qui le numérise,
- un module de transformée de Fourier discrète (26),
- un module d'analyse (27) contenant un module de déconvolution, qui réalise un post-traitement du signal mesuré ainsi transformé en utilisant le signal de test $S_F$ et qui permet d'estimer la réponse $h(t)$ de transmission, telle que $x_s(t)=x(t)*h(t)$, * représentant un produit de convolution.

2. Dispositif selon la revendication 1, dans lequel la partie détection comprend un module de moyennage situé en sortie du convertisseur analogique-numérique (24).

3. Dispositif selon la revendication 1, dans lequel le module d'analyse comprend des moyens d'inter-corrélation entre le signal émis et le signal mesuré.

4. Dispositif selon la revendication 1, dans lequel les moyens de post-traitement réalisent une déconvolution brute, en appliquant l'équation suivante :

$$h_k^F = \frac{y_k^F}{s_k^F}$$

où $h_k^F$, $y_k^F$, et $s_k^F$ correspondent respectivement aux échantillons des vecteurs $\underline{\hat{h}}_F$, $y_F$ et $s_F$, transformées de Fourier discrètes des vecteurs $\underline{\hat{h}}$, $y$ et $s$, chaque période du signal mesurée $x_s(t)$ permettant d'obtenir une suite de vecteurs $\underline{y}_m$ de longueur N, la moyenne obtenue par un moyennage (25) de plusieurs période étant stockée dans un vecteur $\underline{y}$.

5. Dispositif selon la revendication 1 ou la revendication 4, dans lequel les moyens de post-traitement réalisent un algorithme de nettoyage, qui comprend des étapes de :

   - initialisation (étape 43),
   - recherche du maximum (étape 44),
   - nettoyage (étape 46) après un test 45 de condition d'arrêt,
   - mémorisation (étape 47).

6. Dispositif selon la revendication 1, dans lequel le convertisseur analogique-numérique comprend des moyens de sur-échantillonnage.

7. Dispositif selon la revendication 1, comprenant des moyens de filtrage analogique après le convertisseur numérique-analogique.

8. Procédé de réflectométrie multiporteuse pour le diagnostic en ligne d'au moins une ligne de transmission (23), **caractérisé en ce qu'**il comprend les étapes suivantes :

   • en émission dans cette ligne de transmission (23) :

   - une étape de paramétrage d'un signal test $S_F$ tel que :

$$s_F = [0, c_1 e^{j\theta_1}, c_2 e^{j\theta_2}, \dots, c_{N/2-1} e^{j\theta_{N/2-1}}, c_{N/2}, c_{N/2-1} e^{j\theta_{N/2-1}},$$
$$c_{N/2-2} e^{j\theta_{N/2-2}}, \dots, c_1 e^{j\theta_1}]^T$$

   , où N correspond au nombre de sinusoïdes, $C_n \in R+$ est l'amplitude de la $n^{ième}$ sinusoïde, $\theta^n$ est la phase de la $n^{ième}$ sinusoïde,
   - une étape de synthèse de ce signal test par transformée de Fourier discrète inverse, - une étape de conversion numérique-analogique qui délivre à cette ligne de transmission (23) un signal test analogique $x(t)$ qui est un signal périodique,

• en détection de cette ligne de transmission :

- une étape de conversion analogique-numérique du signal mesuré $x_s(t)$ reliée à cette ligne de transmission,
- une étape de transformée de Fourier discrète,
- une étape d'analyse permettant une déconvolution, qui réalise un post-traitement du signal ainsi transformé en utilisant le signal de test $s_F$ et qui permet d'estimer la réponse $h(t)$ de la ligne de transmission (23), telle que $x_s(t)=x(t)*h(t)$, * représentant un produit de convolution.

9. Procédé selon la revendication 8, qui comprend une étape de moyennage située après l'étape de conversion analogique-numérique.

10. Procédé selon la revendication 8, dans lequel l'étape d'analyse comprend une phase d'inter-corrélation entre le signal émis et le signal mesuré.

11. Procédé selon la revendication 8, dans lequel la phase de post-traitement réalise une déconvolution brute, en appliquant l'équation suivante :

$$h_k^F = \frac{y_k^F}{s_k^F}$$

où $h_k^F$, $y_k^F$, et $s_k^F$ correspondent respectivement aux échantillons des vecteurs $\hat{\underline{h}}_F$, $y_F$ et $s_F$, transformées de Fourier discrètes des vecteurs $\hat{\underline{h}}$, $y$ et $s$, chaque période du signal mesurée $x_s(t)$ permettant d'obtenir une suite de vecteurs $\underline{y}_m$ de longueur N, la moyenne obtenue par un moyennage (25) de plusieurs périodes étant stockée dans un vecteur $\underline{y}$.

12. Procédé selon la revendication 8 ou la revendication 11, dans lequel l'étape de post-traitement réalise un algorithme de nettoyage, qui comprend des étapes de :

- initialisation (étape 43),
- recherche du maximum (étape 44),
- nettoyage (étape 46) après un test 45 de condition d'arrêt,
- mémorisation (étape 47).

13. Procédé selon la revendication 9, dans lequel l'étape de conversion analogique-numérique comprend une phase de sur-échantillonnage.

14. Procédé selon la revendication 9, comprenant une phase de filtrage analogique après l'étape de conversion numérique-analogique.

**Patentansprüche**

1. Mehrträger-Reflektometrievorrichtung zur online-Diagnose zumindest einer Übertragungsleitung (23), **dadurch gekennzeichnet, dass** sie enthält:

• einen Emissionsteil, der mit dieser Übertragungsleitung (23) verbunden ist und aufeinanderfolgend enthält:

- ein Parametrierungsmodul (20) zum Parametrieren eines Prüfsignals $S_F$, derart, dass:

$$S_F = [0, c_1 e^{j\theta 1}, c_2 e^{j\theta 2}, ...., C_{N/2-1} e^{j\theta N/2-1}, C_{N/2}, C_{N/2-1} e^{j\theta N/2-1}, C_{N/2-2} e^{j\theta N/2-2}, ..., c_1 e^{j\theta 1}]^T$$

worin N der Anzahl an Sinuskurven entspricht,
$c_n \in R^+$ die Amplitude der n-ten Sinuskurve ist,
$\theta^n$ die Phase der n-ten Sinuskurve ist,

- ein Synthesemodul (21) zur Synthese dieses Prüfsignals durch inverse, diskrete Fourier-Transformierte,
- einen Digital-Analog-Wandler (22), der mit dieser Übertragungsleitung (23) verbunden ist und an diese ein analoges Prüfsignal x(t) ausgibt, das ein periodisches Signal ist,

• einen Detektionsteil, der mit dieser Übertragungsleitung (23) verbunden ist und aufeinanderfolgend enthält:

- einen Analog-Digital-Wandler (24), der mit dieser Übertragungsleitung (23) verbunden ist und ein Mess-signal $x_s$(t) empfängt und digitalisiert,
- ein Modul zur diskreten Fourier-Transformation (26),
- ein Analysemodul (27) mit einem Dekonvolutionsmodul, das eine Nachverarbeitung des so umgewandelten Messsignals durchführt, indem es das Prüfsignal $S_F$ verwendet, und das gestattet, die Übertragungsantwort h(t) abzuschätzen, so dass $x_s$(t) = x(t) * h(t), wobei * ein Konvolutionsprodukt darstellt.

2. Vorrichtung nach Anspruch 1, wobei der Detektionsteil ein Mittelwertbildungsmodul enthält, das sich am Ausgang des Analog-DigitalWandlers (24) befindet.

3. Vorrichtung nach Anspruch 1, wobei das Analysemodul Mittel zur Interkorrelation zwischen dem ausgegebenen Signal und dem Messsignal enthält.

4. Vorrichtung nach Anspruch 1, wobei die Nachverarbeitungsmittel eine Roh-Dekonvolution durchführen, indem sie die nachfolgende Gleichung anwenden:

$$h_k^F = \frac{Y_k^F}{S_k^F}$$

worin $h_k^F$, $Y_k^F$ und $S_k^F$ den jeweiligen Abtastwerten der Vektoren $\hat{\underline{h}}_F$, $y_F$ und $s_F$, den diskreten Fourier-Transformierten der Vektoren $\hat{\underline{h}}$, y und s entsprechen, wobei jede Periode des Messsignals $x_\varepsilon$(t) gestattet, eine Folge von Vektoren $\underline{y}_m$ der Länge N zu erhalten, wobei der durch eine Mittelwertbildung (25) aus mehreren Perioden erhaltene Mittelwert in einem Vektor $\underline{y}$ abgelegt wird.

5. Vorrichtung nach Anspruch 1 oder Anspruch 4, wobei die Nachverarbeitungsmittel einen Reinigungsalgorithmus durchführen, der die nachfolgenden Schritte umfasst:

- Initialisieren (Schritt 43),
- Suche nach dem Maximalwert (Schritt 44),
- Reinigen (Schritt 46) nach einer Stoppbedingungsprüfung 45,
- Abspeichern (Schritt 47).

6. Vorrichtung nach Anspruch 1, wobei der Analog-Digital-Wandler Überabtastungs-Mittel enthält.

7. Vorrichtung nach Anspruch 1, enthaltend analoge Filtermittel nach dem Digital-Analog-Wandler.

8. Verfahren zur Mehrträger-Reflektometrie zur online-Diagnose zumindest einer Übertragungsleitung (23), **dadurch gekennzeichnet, dass** es die nachfolgenden Schritte umfasst:

• beim Senden in dieser Übertragungsleitung (23):

- einen Schritt des Parametrierens eines Prüfsignals $S_F$, derart, dass:

$$S_F = [0, c_1 e^{j\theta 1}, c_2 e^{j\theta 2}, ...., C_{N/2-1} e^{j\theta N/2-1}, C_{N/2}, C_{N/2-1} e^{j\theta N/2-1}, C_{N/2-2} e^{j\theta N/2-2}, ..., c_1 e^{j\theta 1}]^T$$

worin N der Anzahl an Sinuskurven entspricht,
$c_n \in R^+$ die Amplitude der n-ten Sinuskurve ist,
$\theta^n$ die Phase der n-ten Sinuskurve ist,

- einen Schritt der Synthese dieses Prüfsignals durch inverse, diskrete Fourier-Transformierte,
- einen Schritt der Digital-Analog-Umwandlung, wodurch an diese Übertragungsleitung (23) ein analoges Prüfsignal x(t) ausgegeben wird, das ein periodisches Signal ist,

• bei der Detektion dieser Übertragungsleitung:

- einen Schritt der Analog-Digital-Umwandlung des Messsignals $x_s$(t), das mit dieser Übertragungsleitung verbunden ist,
- einen Schritt der diskreten Fourier-Transformation,
- einen Analyseschritt, der eine Dekonvolution gestattet, die eine Nachverarbeitung des so umgewandelten Signals durchführt, indem das Prüfsignal $S_F$ verwendet wird, und gestattet, die Antwort h(t) der Übertragungsleitung (23) abzuschätzen, so dass $x_s$(t) = x(t) * h(t), wobei * ein Konvolutionsprodukt darstellt.

**9.** Verfahren nach Anspruch 8, umfassend einen Schritt der Mittelwertbildung, der nach dem Schritt der Analog-Digital-Umwandlung erfolgt.

**10.** Verfahren nach Anspruch 8, wobei der Analyseschritt eine Phase der Interkorrelation zwischen dem ausgegebenen Signal und dem Messsignal umfasst.

**11.** Verfahren nach Anspruch 8, wobei die Nachverarbeitungsphase eine Roh-Dekonvolution durchführt, indem sie die nachfolgende Gleichung anwendet:

$$h_k^F = \frac{Y_k^F}{S_k^F}$$

worin $h_k^F$, $Y_k^F$ und $S_k^F$ den jeweiligen Abtastwerten der Vektoren $\hat{\underline{h}}_F$, $y_F$ und $s_F$, den diskreten Fourier-Transformierten der Vektoren $\underline{h}$, y und s entsprechen, wobei jede Periode des Messsignals $x_\varepsilon$(t) gestattet, eine Folge von Vektoren $\underline{y}_m$ der Länge N zu erhalten, wobei der durch eine Mittelwertbildung (25) aus mehreren Perioden erhaltene Mittelwert in einem Vektor $\underline{y}$ abgelegt wird.

**12.** Verfahren nach Anspruch 8 oder Anspruch 11, wobei der Schritt der Nachverarbeitung einen Reinigungsalgorithmus durchführt, der die nachfolgenden Schritte umfasst:

- Initialisieren (Schritt 43),
- Suche nach dem Maximalwert (Schritt 44),
- Reinigen (Schritt 46) nach einer Stoppbedingungsprüfung 45,
- Abspeichern (Schritt 47).

**13.** Verfahren nach Anspruch 9, wobei der Schritt der Analog-Digital-Umwandlung eine Phase der Überabtastung umfasst.

**14.** Vorrichtung nach Anspruch 9, umfassend eine Phase analoger Filterung nach der Digital-Analog-Umwandlung.

**Claims**

**1.** Multicarrier reflectometry device for on-line diagnosis of at least one transmission line (23), **characterised in that** it comprises:

• a transmission part connected to this transmission line, which comprises successively:

- a module (20) for parameterising a test signal $S_F$, such that:

$$s_F = [\,0\,, c_1 e^{j\theta_1}\,, c_2 e^{j\theta_2}\,, \ldots\,, c_{N/2-1} e^{j\theta_{N/2-1}}\,, c_{N/2}\,, c_{N/2-1} e^{j\theta_{N/2-1}}\,,$$

$$c_{N/2-2} e^{j\theta_{N/2-2}}\,, \ldots\,, \ c_1 e^{j\theta_1}\,]^T$$

where N corresponds to the number of sinusoids,

$c_n \in R^+$ is the amplitude of the $n^{th}$ sinusoid, $\theta_n$ is the phase of the $n^{th}$ sinusoid,

- a module (21) for synthesising this test signal by inverse discrete Fourier transform,
- a digital to analogue converter (22), connected to this transmission line (23), which delivers to the latter an analogue test signal x(t) that is a periodic signal,

• a detection part, connected to this transmission line (23), which comprises successively:

- an analogue to digital converter (24), connected to this transmission line (23), which receives a measured signal $x_s(t)$ and digitises it,
- a discrete Fourier transform module (26),
- an analysis module (27) containing a deconvolution module, which performs a post-processing of the measured signal thus transformed using the test signal $S_F$ and which makes it possible to estimate the transmission response h(t), such that $x_s(t)=x(t)*h(t)$, * representing a convolution product.

2. Device according to claim 1, wherein the detection part comprises an averaging module situated at the output of the analogue to digital converter (24).

3. Device according to claim 1, wherein the analysis module comprises means of intercorrelation between the transmitted signal and the measured signal.

4. Device according to claim 1, wherein the post-processing means perform a raw deconvolution, applying the following equation:

$$h_k^F \ = \ \frac{y_k^F}{s_k^F}$$

where $h_k^F$ , $y_k^F$ , and $s_k^F$ correspond respectively to the samples of the vectors $\underline{\hat{h}}_F$, $y_F$ and $s_F$, discrete Fourier transforms of the vectors $\underline{\hat{h}}$, y and s, each period of the measured signal $x_s(t)$ making it possible to obtain a series of vectors $\underline{y}_m$ of length N, the average obtained by an averaging (25) of several periods being stored in a vector $\underline{y}$.

5. Device according to claim 1 or claim 4, wherein the post-processing means perform a cleaning algorithm, which comprises steps of:

- initialisation (step 43),
- search for the maximum (step 44),
- cleaning (step 46) after a stopping condition test 45,
- storage (step 47).

6. Device according to claim 1, wherein the analogue to digital converter comprises supersampling means.

7. Device according to claim 1, comprising analogue filtering means after the digital to analogue converter.

8. Multicarrier reflectometry method for the on-line diagnosis of at least one transmission line (23), **characterised in that** it comprises the following steps:

• in transmission in this transmission line (23):

- a step of parameterising a test signal $S_F$ such that:

$$s_F = [0, c_1 e^{j\theta_1}, c_2 e^{j\theta_2}, \ldots, c_{N/2-1} e^{j\theta_{N/2-1}}, c_{N/2}, c_{N/2-1} e^{j\theta_{N/2-1}},$$

$$c_{N/2-2} e^{j\theta_{N/2-2}}, \ldots, c_1 e^{j\theta_1}]^T$$

where N corresponds to the number of sinusoids,
$c_n \in R^+$ is the amplitude of the $n^{th}$ sinusoid, $\theta_n$ is the phase of the $n^{th}$ sinusoid,

- a step of synthesising this test signal by inverse discrete Fourier transform,
- a step of digital to analogue conversion that delivers to this transmission line (23) an analogue test signal x(t) that is a periodic signal,

• in detection for this transmission line:

- a step of analogue to digital conversion of the measured signal xs(t) connected to this transmission line,
- a discrete Fourier transform step,
- an analysis step enabling a deconvolution, which performs a post-processing of the signal thus transformed using the test signal $s_F$ and which makes it possible to estimate the response h(t) of the transmission line (23), such that $x_s(t)=x(t)*h(t)$, * representing a convolution product.

9. Method according to claim 8, which comprises an averaging step situated after the analogue to digital conversion step.

10. Method according to claim 8, wherein the analysis step comprises an intercorrelation phase between the transmitted signal and the measured signal.

11. Method according to claim 8, wherein the post-processing phase performs a raw deconvolution, applying the following equation:

$$h_k^F = \frac{y_k^F}{s_k^F}$$

where $h_k^F$, $y_k^F$, and $s_k^F$ correspond respectively to the samples of the vectors $\underline{\hat{h}}_F$, $y_F$ and $s_F$, discrete Fourier transforms of the vectors $\underline{\hat{h}}$, y and s, each period of the measured signal $x_s(t)$ making it possible to obtain a series of vectors $\underline{y}_m$ of length N, the average obtained by an averaging (25) of several periods being stored in a vector $\underline{y}$.

12. Method according to claim 8 or claim 11, wherein the post-processing step performs a cleaning algorithm, which comprises steps of:

- initialisation (step 43),
- search for the maximum (step 44),
- cleaning (step 46) after a stopping condition test (45),
- storage (step 47).

13. Method according to claim 9, wherein the analogue to digital conversion step comprises a supersampling phase.

14. Method according to claim 9, comprising an analogue filtering phase after the digital to analogue conversion.

FIG.1

FIG.2

FIG.3

FIG.4

FIG.5A

FIG.5B

Initialisation

$\underline{c} = 0$

$\underline{d} = \text{IDFT} \; [\underline{y}_F \odot \underline{s}_F^*]$

$\underline{r}_{ss} = \text{IDFT} \; [\underline{s}_F \odot \underline{s}_F^*]$

43

Recherche du maximum

$\tau = \arg\max |\underline{d}|$

$m = \dfrac{d_\tau}{\max(\underline{r}_{ss})}$

44

45

oui

Condition d'arrêt

non

46

Nettoyage

$\underline{d} = \underline{d} - m\underline{r}_{ss}^{\emptyset\tau}$

Memorisation

$\underline{c} = \underline{c} + m\underline{\delta}_\tau$

47

Fin

FIG.6

FIG.7A

FIG.7B

FIG.8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Analysis of spread spectrum time domain reflectometry for wire fault location. **P. SMITH ; C. FURSE ; J. GUNTHER.** Sensors Journal. IEEE, Décembre 2005, vol. 5, 1469-1478
- **CHET LO ; C. FURSE.** Noise-domain reflectometry for locating wiring faults. *Electromagnetic Compatibility, IEEE Transactions on,* Février 2005, vol. 47 (1), 97-104
- Multicarrier reflectometry. **S. NAIK ; C.M. FURSE ; B. FARHANG-BOROUJENY.** Sensors Journal. IEEE, Juin 2006, vol. 6, 812-818

- **M. R. SCHROEDER.** Synthesis of low-peak-factor signals and binary sequences with low autocorrelation. *IEEE Transaction on information Theory,* Janvier 1970, vol. 16, 85-89
- **C. BUCCELLA ; M. FELIZIANI ; G. MANZI.** Detection and localization of defects in shielded cables by time-domain measurements with uwb pulse injection and clean algorithm postprocessing. *IEEE Transactions on Electromagnetic Compatibility,* Novembre 2004, vol. 46 (4), 597-605